Europäisches Patentamt

European Patent Office

Office européen des brevets

(11) Publication number: **0 452 889 A2**

# EUROPEAN PATENT APPLICATION

(21) Application number: 91106071.3

(22) Date of filing: 16.04.91

(51) Int. Cl.⁵: **H01L 21/285, H01L 21/321**

(30) Priority: 16.04.90 US 509928
16.04.90 US 510307
16.04.90 US 510340

(43) Date of publication of application:
**23.10.91 Bulletin 91/43**

(84) Designated Contracting States:
**BE DE ES FR GB IT NL**

(71) Applicant: **APPLIED MATERIALS, INC.**
**3050 Bowers Avenue**
**Santa Clara California 95054(US)**

(72) Inventor: **Nulman, Jaim**
**4155-G El Camino Way**
**Palo Alto, CA 94306(US)**

(74) Representative: **Diehl, Hermann Dr. et al**
**Diehl & Glaeser, Hiltl & Partner**
**Flüggenstrasse 13**
**W-8000 München 19(DE)**

(54) Process for forming titanium silicide on a semiconductor wafer.

(57) A low nitrogen pressure process is disclosed for forming a conductive layer of titanium silicide on a silicon semiconductor wafer which comprises the steps of forming a titanium layer over the wafer in a vacuum deposition chamber in the substantial absence of oxygen and/or oxygen-bearing gases; transferring the titanium coated wafer to a sealed annealing chamber without substantially exposing the newly formed titanium layer to oxygen and/or oxygen-bearing gases; and annealing the titanium-coated silicon semiconductor wafer in the sealed annealing chamber, in the substantial absence of oxygen and/or oxygen-bearing gases, while maintaining a nitrogen pressure ranging from about 100 milliTorr to about 100 Torr, preferably from about 500 milliTorr to about 10 Torr, and most preferably from about 1 Torr to about 10 Torr, to form a titanium silicide layer as well as titanium nitride on the surface which inhibits migration of underlying silicon to the surface.

CLEANING A SILICON SEMICONDUCTOR WAFER IN A CLEANING CHAMBER USING ONE OR MORE REACTIVE GASES WITH AN RF PLASMA

MOVING THE CLEANED WAFER TO A VACUUM DEPOSITION CHAMBER WITHOUT EXPOSING THE CLEANED WAFER TO OXYGEN-BEARING GASES

DEPOSITING A LAYER OF TITANIUM ON THE CLEANED SEMICONDUCTOR WAFER

MOVING THE WAFER FROM THE VACUUM DEPOSITION CHAMBER TO AN ANNEALING CHAMBER WITHOUT EXPOSING THE COATED WAFER TO OXYGEN-BEARING GASES

ANNEALING THE COATED WAFER WHILE MAINTAINING A LOW NITROGEN PRESSURE IN THE ANNEALING CHAMBER OF ABOUT 0.1 - 100 TORR, PREFERABLY ABOUT 0.5 - 10 TORR, AND MOST PREFERABLY ABOUT 1 - 10 TORR

Figure 1

This invention relates to the processing of a semiconductor wafer to form an integrated circuit structure thereon. More particularly, this invention relates to a process for forming a layer of titanium silicide on a semiconductor wafer.

In the conventional formation of a titanium silicide layer, as a part of an integrated circuit structure on a semiconductor wafer such as a silicon wafer, those surfaces of the wafer on which the titanium silicide layer is to be formed are first cleaned to remove any materials which might interfere with reaction between the subsequently deposited titanium layer and the exposed silicon portions of the wafer. The surfaces are conventionally cleaned in a vacuum chamber using an inert gas such as argon with an rf plasma. This cleaning step is sometimes preceded by an oxide wet etch.

Following these cleaning steps, a layer of titanium metal is conventionally deposited over the cleaned wafer structure, for example, using a vacuum sputtering deposition (PVD) process, usually to a thickness ranging from about 100 to about 1000 Angstroms. *

The titanium coated wafer is then conventionally removed from the PVD chamber and transported through the ambient atmosphere to separate annealing apparatus where the structure is annealed in a nitrogen atmosphere and in the absence of oxygen (which would react with the titanium). Usually this annealing step comprises a rapid anneal where the structure is rapidly heated to the annealing temperature of from about 650°C to about 675°C in a few seconds and then maintained at this annealing temperature for from about 20 to about 60 seconds.

The use of a nitrogen atmosphere in the annealing chamber results in the simultaneous formation of a titanium nitride layer as the titanium reacts with the silicon to form titanium silicide. This titanium nitride acts as a blocking layer to prevent migration of silicon atoms to the surface, from the underlying silicon.

However, to satisfactorily form the desired titanium nitride blocking layer, it is necessary that the nitrogen atoms penetrate into the titanium layer. Because of the introduction of oxygen onto the newly deposited titanium surface on the semiconductor wafer in the prior art practice, and the resultant formation of undesirable titanium oxides, it is conventionally necessary to use high concentrations of nitrogen in the annealing step to permit formation of the desired titanium nitride blocking layer.

It would be preferable to be able to conduct the annealing step using a lower pressure of nitrogen to thereby reduce the time needed to backfill the chamber with nitrogen and increase the throughput time of the process.

It is, therefore, an object of this invention to provide a process for the formation of titanium silicide on a semiconductor wafer using a low pressure or Concentration of nitrogen while still forming sufficient titanium nitride to inhibit migration of unreacted silicon atoms to the top surface of the resulting titanium silicide and/or titanium layer. This object is solved by the process of independent claims 1 and 3. Further features and details of the invention are evident from the dependent claims, the description, examples and the drawings. The claims are intended to be understood as a first non-limiting approach of defining the invention in general terms.

It is another aspect of this invention to provide a process for the formation of titanium silicide on a semiconductor wafer wherein oxygen is sufficiently excluded from the process to permit use of a low nitrogen pressure during formation of the titanium silicide, while still forming a sufficient amount of titanium nitride to prevent migration of unreacted silicon atoms to the top surface of the resulting layer.

It is still another aspect of this invention to provide a process for the formation of titanium silicide on a semiconductor wafer wherein oxygen is sufficiently excluded from the process, by transferring the wafer from a titanium deposition chamber to an annealing chamber under vacuum without exposing the titanium coated wafer to oxygen or oxygen-bearing gases, to permit use of a low nitrogen pressure during formation of the titanium silicide, while still forming a sufficient amount of titanium nitride to prevent migration of unreacted silicon atoms to the top surface of the resulting layer.

It is a further aspect of this invention to provide a process for the formation of titanium silicide on a semiconductor wafer wherein oxygen is sufficiently excluded from the process, by first cleaning the wafer using a reactive rf ion etch prior to depositing a layer of titanium on the wafer, and by then transferring the wafer from the titanium deposition chamber to an annealing chamber under vacuum, without exposing the cleaned wafer to oxygen-bearing gases, to permit use of a low nitrogen pressure during formation of the titanium silicide, while still forming a sufficient amount of titanium nitride to prevent migration of unreacted silicon atoms to the top surface of the resulting layer.

These and other aspects of the invention will be apparent from the following description and accompanying drawings.

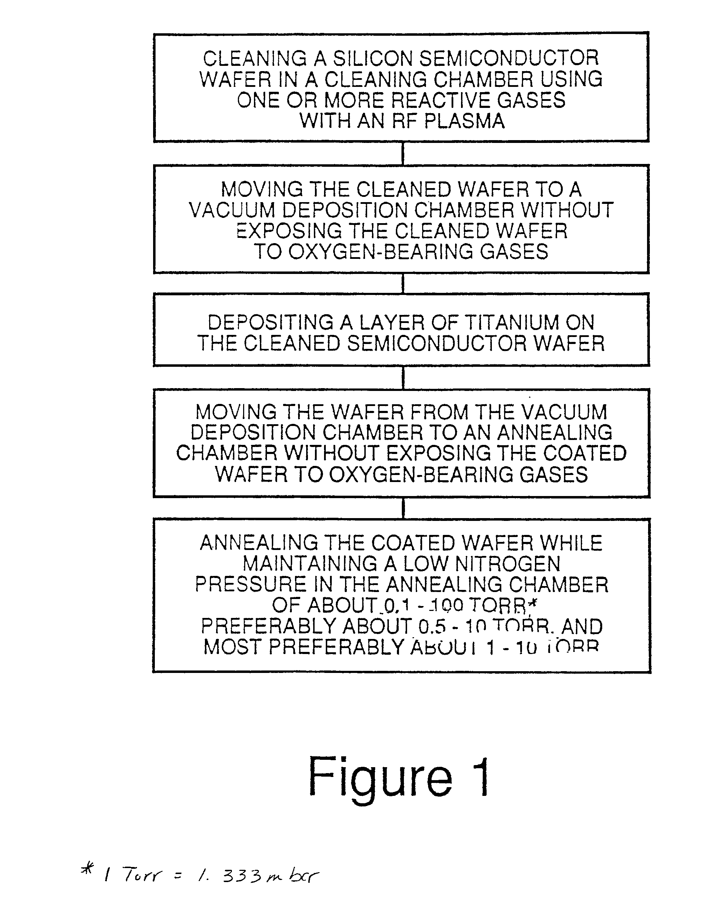

Figure 1 is a flowsheet illustrating an embodi-

* 1 Angstrom = 0.1 nm

ment of the process of the invention.

Figure 2 is a top view of an apparatus suitable for carrying out the process of the invention.

Figure 3 is a fragmentary vertical cross-sectional view of a titanium silicide layer formed on a silicon wafer.

Figure 4 is a graph showing the sheet resistance of the titanium silicide layer as a function of nitrogen vacuum level in the annealing chamber.

The process of the invention provides for the formation of a titanium silicide layer on a semiconductor wafer, in the substantial absence of oxygen and/or oxygen-bearing gases such as air, using a low pressure nitrogen-bearing atmosphere in an annealing chamber while still forming a sufficient amount of titanium nitride to block the migration of unreacted silicon atoms to the surface during the anneal.

In one aspect, the process of the invention comprises the formation of a titanium silicide layer on a semiconductor wafer, in the substantial absence of oxygen-bearing gases, using a low pressure nitrogen-bearing atmosphere in an annealing chamber, wherein oxygen-bearing gases are excluded by the transfer of the semiconductor wafer, under vacuum and in the substantial absence of oxygen-bearing gases, from a titanium deposition chamber to the annealing chamber.

In another aspect the process of the invention further comprises the formation of a titanium silicide layer on a semiconductor wafer, in the substantial absence of oxygen-bearing gases, using a low pressure nitrogen-bearing atmosphere in an annealing chamber, wherein oxygen-bearing gases are also excluded by the cleaning of the wafer, prior to the titanium deposition step, using a reactive rf ion etch to more thoroughly remove oxygen and/or oxygen-bearing gases from the wafer surface prior to the titanium deposition step, followed by transfer of the cleaned wafer, under vacuum and in the substantial absence of oxygen-bearing gases, to the titanium deposition chamber.

The process of forming a titanium silicide layer on a semiconductor wafer, in the substantial absence of oxygen and/or oxygen-bearing gases such as air, is described and claimed in copending Eurpean Patent Application No. -_____ (attorney's file A5418-EP) assigned to the assignee of this invention and entitled, "Process for Forming Titanium Silicide on a Semiconductor Wafer", the content of which is incorporated by reference and a copy of which is enclosed. * In that application there is described a process for forming titanium silicide on a semiconductor wafer wherein oxygen-bearing gases are excluded by the transfer of the semiconductor wafer, under vacuum and in the substantial absence of oxygen-bearing gases, from a titanium deposition chamber to the annealing chamber, as well as by the cleaning of the wafer, prior to the titanium deposition step, using a reactive rf ion etch to more thoroughly remove oxygen and/or oxygen-bearing gases from the wafer surface prior to the titanium deposition step, followed by transfer of the cleaned wafer, under vacuum and in the substantial absence of oxygen-bearing gases, to the titanium deposition chamber.

In accordance with the practice of the present invention, the formation of a titanium silicide layer on a semiconductor wafer using the oxygen exclusion steps of the cross-referenced copending application, in combination with the use of a low pressure nitrogen atmosphere during the annealing step, results in the formation of a titanium silicide layer on a semiconductor wafer, while still forming the required amount of titanium nitride needed to adequately block migration of unreacted silicon atoms to the surface.

By use of the expressions herein "substantial absence of oxygen-bearing gas" and/or "without substantially exposing the newly formed titanium layer to oxygen and/or oxygen-bearing gases" is meant that in the chambers respectively used for the titanium deposition and for annealing, as well as in the vacuum chamber used for the transfer of the wafer therebetween, the atmosphere will contain less than 10 ppm oxygen in any of the chambers.

By use of the term "unreacted silicon atoms" is generally meant silicon which has not reacted with titanium to form the corresponding silicide - or which is not already oxidized to form silicon oxide such as the $SiO_2$ insulation regions of the semiconductor wafer under portions of the deposited titanium layer.

By use of the term herein "in a low pressure nitrogen-bearing atmosphere" is meant a nitrogen pressure or vacuum level in the annealing chamber ranging from about 100 milliTorr * up to about 100 Torr. In a preferred embodiment, the nitrogen pressure in the annealing chamber will range from about 500 milliTorr to about 10 Torr, and most preferably from about 1 Torr to about 10 Torr. The nitrogen may come from $N_2$ or from any other source which will decompose to provide a source of nitrogen without adding oxygen-bearing gases to the atmosphere, e.g., $NH_3$.

* (Annex A)

* 1 milliTorr = 1.3 x 10$^6$ bar

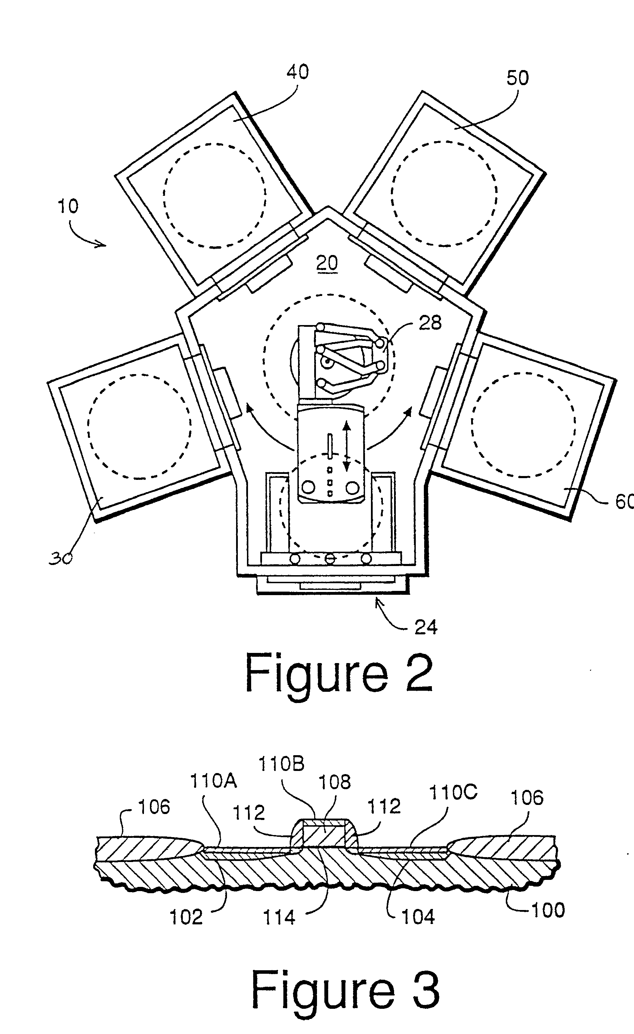

Turning now to Figure 2, an apparatus useful for carrying out the process of the invention is generally indicated at 10 which comprises a sealed central chamber 20 into which a wafer may be loaded through a cassette load lock 24. Central chamber 20 may be maintained at a vacuum ranging from about $10^{-9}$ to about $10^{-5}$ Torr. * In particular, oxygen and other oxygen-bearing gases such as air are excluded from central chamber 20.

Robotic means 28 may be provided within central chamber 20 to transfer the wafer between a cleaning chamber 30, a PVD titanium deposition chamber 40, and an annealing chamber 50 through central chamber 20. An optional degassing chamber 60 may also be provided as a part of apparatus 10, which will also be accessible through central vacuum chamber 20.

Multi-chambered vacuum apparatus for the processing of semiconductor wafers is generally described in Toshima U.S. Patent 4,785,962, cross-reference to which is hereby made, and is commercially available, such as, for example, a 5000 Series wafer processing apparatus available from Applied Materials, Inc. in Santa Clara, CA, and such apparatus may be modified for the practice of the present invention.

In the practice of the process of the invention, a single wafer or a group of wafers on a tray is admitted into central chamber 20 of vacuum apparatus 10 through load lock 24 and then a single wafer is transferred to cleaning chamber 30 where the wafer is cleaned to remove any foreign materials from the wafer and, in particular, any oxides from the surface of the exposed silicon.

The wafer may be cleaned using a conventional inert gas RF etch, using argon as the inert gas. However, in accordance with a preferred embodiment of the process of the invention, the wafer is preferably cleaned using a reactive rf ion process such as a $NF_3$/argon mixture by flowing into cleaning chamber 30 from about 2 sccm to about 500 sccm of at least one reactive gas such as $NF_3$ and from about 10 sccm to about 1000 sccm of a carrier gas such as argon while maintaining a vacuum of from about 1 to about 50 milliTorr in cleaning chamber 30 and an rf plasma at a power level ranging from about 20 to about 500 watts. The cleaning chamber is maintained at a temperature within a range of from about 27° C to about 200° C during the cleaning step which is carried out for a period of from about 1 to about 500 seconds.

Examples of reactive gases which can be used to carry out the reactive rf ion etch cleaning step of the process include not only $NF_3$, but also fluorinated 1-2 carbon hydrocarbons such as, for example, $CHF_3$ and $CF_4$, as well as mixtures of same.

After the wafer has been cleaned, it is transferred out of cleaning chamber 30 back to central chamber 20 and then into deposition chamber 40 where a layer of titanium, having a thickness range of from about 100 to about 5000 Angstroms, preferably from about 100 to about 1000 Angstroms, and typically about 500 Angstroms, is conventionally deposited onto the wafer surface using, for example, a PVD sputtering process. It will be noted that in the preferred embodiment of the invention, the cleaned wafer removed from cleaning chamber 30 is not exposed to air or any other oxygen-containing gases, but is rather moved from cleaning chamber 30 through vacuum chamber 20 directly to deposition chamber 40.

After deposition of the titanium layer onto the wafer, the wafer is removed from deposition chamber 40 and, in accordance with the invention, directly transferred to annealing chamber 50 through vacuum chamber 20 without any exposure to oxygen or other oxygen-bearing gases, such as air, which might otherwise adsorb on or enter into the newly deposited titanium layer.

The annealing portion of the process is then carried out in a first annealing step at a temperature ranging from about 600° C up to about 695° C, and preferably at a temperature ranging from about 650° C to about 675° C. This first annealing step is preferably carried out under rapid anneal conditions where the wafer is ramped up to the annealing temperature at a rate of from about 5° C/second to about 150° C/second, typically about 80° C/second, and the first annealing step is then carried out for a period of from about 20 to about 60 seconds.

During this first anneal step, one or more nitrogen-bearing gases are flowed into annealing chamber 50 at a rate ranging from about 500 to about 10,000 sccm (depending upon the vacuum pump capacity) while maintaining the desired low nitrogen pressure in said annealing chamber, i.e., within a range of from about 100 milliTorr to about 100 Torr, preferably from about 500 milliTorr to about 10 Torr, and most preferably from about 1 Torr to about 10 Torr.

After this first anneal step, the titanium nitride (TiN), formed over the titanium silicide as well as over silicon oxide ($SiO_2$) portions of the wafer, may be selectively removed using a wet etch such as a mixture of 4 parts by weight $H_2O$, 1 part by weight $H_2O_2$, and 1 part by weight $NH_4OH$ which will remove unreacted titanium and titanium nitride, in preference to titanium silicide and/or silicon oxide.

The wafer may be then again annealed in a second rapid anneal step similar to the first anneal step, but at a temperature ranging from about

* 1 Torr = 1.333 mbar

800°C to about 900°C for from about 20 to 60 seconds. This higher anneal temperature serves to convert the less stable C49 phase titanium silicide to the more stable C54 phase, as is well known to those skilled in this art.

In another aspect of the best mode of practicing the claimed invention, the two annealing steps may be carried out without an intervening wet etch step by first annealing the wafer at a temperature of from about 500°C to about 695°C, preferably from about 600°C to about 675°C, for from 20 to 60 seconds, followed by a second rapid anneal step at a temperature of from about 800°C to about 900°C for an additional time period of from about 20 seconds to about 60 seconds, followed by the previously described conventional wet etch step to selectively remove titanium nitride. This annealing and etching process is described and claimed in copending European Patent Application No. _____ (attorney's file A5424-EP) assigned to the assginee of this invention and entitled, "Process for Forming a Layer of Titanium Silicide on a Semiconductor Wafer", which is incorporated by reference and a copy of which is enclosed (Annex B).

Figure 3 shows the structure formed by the process of the invention, after the first anneal step and subsequent etch. A silicon semiconductor wafer 100 is shown having silicon oxide (SiO₂) isolation regions 106 previously formed in the surface of the wafer and an MOS structure comprising a source region 102, a drain region 104, and a gate electrode 108 formed over gate oxide 114 with oxide spacers 112 formed on the sidewalls of gate electrode 108. Titanium silicide portions 110A, 110B, and 110C have been respectively formed by the process of the invention over the source region, the gate electrode, and the drain region as a part of the construction of the electrical contacts for the MOS device.

The following example will serve to further illustrate the process of the invention.

A group of silicon wafer samples were processed in accordance with the process of the invention wherein each of the wafer samples was first cleaned in a reactive rf ion etch for 40 seconds at a pressure of 3 milliTorr, a temperature of 27°C, and a plasma power level of 150 watts, using a mixture of 10 volume % NF₃ and the balance argon carrier gas flowing into the cleaning chamber at 15 sccm.

Each of the cleaned wafers was then individually transferred directly from the cleaning chamber through a central vacuum chamber directly to a titanium sputtering chamber, without exposure of the cleaned wafer to air or other oxygen-bearing gases, where 500 Angstroms of titanium was sputtered onto the cleaned silicon wafer surfaces by a physical vacuum deposition (PVD) process.

The coated wafer was then removed from the PVD chamber and transferred through a central vacuum chamber, without exposing the wafer to air or other oxygen-bearing gases, to an annealing chamber where the coated sample wafer was then annealed, in a single annealing step, at an annealing temperature of about 675°C by a rapid thermal anneal process (RTP) at a low nitrogen pressure for 20 seconds by ramping the respective wafer up to the anneal temperature at a rate of 80°C/sec.

The respective nitrogen pressures used in the annealing of the samples were 5 Torr, 1 Torr, 500 milliTorr, 100 milliTorr, and about 4 milliTorr. Another sample wafer was annealed at 800 Torr as a control.

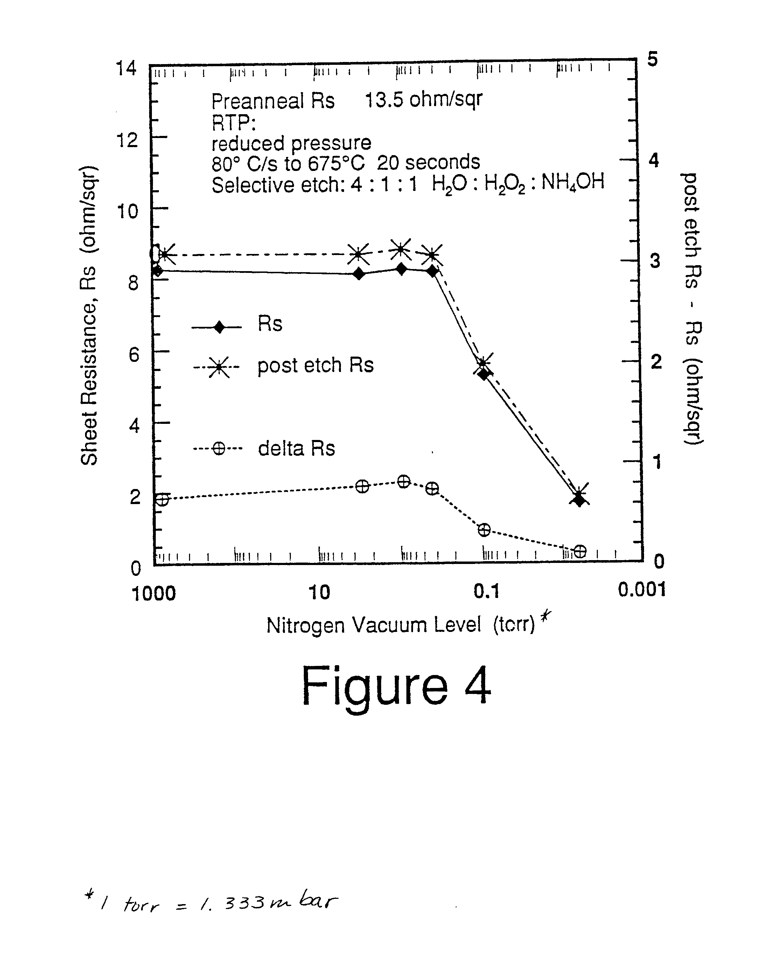

The sheet resistances of the resulting titanium nitride/titanium silicide layers on the samples formed at the various low nitrogen pressures, as well as the control, were then measured. The results are plotted in the graph of Figure 4 along the line of solid diamonds. It will be seen that the sheet resistance is relatively constant between nitrogen pressures ranging from the 800 Torr control all the way down to the 500 milliTorr sample.

Each of the samples was then etched to remove the titanium nitride, as well as any remaining unreacted titanium, and the sheet resistance of each sample wafer was again measured and plotted in the graph of Figure 4 along the starred line. While the sheet resistance of the remaining titanium silicide layer on each sample is slightly higher than the sheet resistance of the combined titanium nitride/titanium silicide layers, it will be again noted that the results are fairly constant down to a nitrogen pressure as low as 500 milliTorr.

Thus, the invention provides an improved process for forming a layer of titanium silicide on the surface of a semiconductor wafer using a low nitrogen pressure anneal wherein excluding oxygen and/or oxygen-bearing gases such as air from the wafer, after deposition of the titanium layer thereon, as well as during the cleaning step, permits use of lower nitrogen pressures during the initial annealing step, while still providing sufficient nitrogen to permit formation of a titanium nitride blocking layer during the anneal whereby essentially no silicon can migrate to the surface from either the underlying silicon oxide portions of the wafer or from/through the newly formed titanium silicide layer. This use of such lower nitrogen pressure levels in the annealing portion of the process permits higher throughput of wafers through the process by reducing pump down and refill times, as well as reduction of potential particulate matter.

According to a special aspect of the invention the low nitrogen pressure process for forming titanium silicide on a silicon semiconductor wafer comprises the steps:

a) providing a silicon semiconductor wafer having one or more silicon surface regions on which said titanium silicide is to be formed;

b) cleaning said wafer in a sealed cleaning chamber using an rf plasma and a gaseous mixture which includes at least one reactive gas;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing station without substantially exposing the newly formed titanium layer to oxygen and/or oxygen-bearing gases by transferring said wafer through a sealed central chamber which is interconnected to both said vacuum deposition chamber and said sealed annealing chamber; and

f) annealing the titanium-coated silicon semiconductor wafer in said annealing chamber in a first annealing step at a temperature ranging from about 600°C to about 695°C for a time period ranging from about 20 seconds to about 60 seconds by raising the temperature of the wafer at a rate of from about 5°C/second to about 150°C/second while maintaining a low nitrogen pressure of from about 500 milliTorr to about 100 Torr in said annealing chamber, and in the substantial absence of oxygen and/or oxygen-bearing gases, to form said titanium silicide as well as titanium nitride on the surface to inhibit migration of underlying silicon to the surface.

In this aspect, preferably said annealing step further includes maintaining a low nitrogen pressure within said annealing chamber ranging from about 500 milliTorr to about 10 Torr, more preferably about 1 Torr to about 10 Torr.

According to a further special aspect of the invention the low nitrogen pressure process for forming titanium silicide on a silicon semiconductor wafer comprises the steps:

a) providing a silicon semiconductor wafer having one or more silicon surface regions on which said titanium silicide is to be formed;

b) cleaning said wafer in a sealed cleaning chamber using an rf plasma and a gaseous mixture containing at least one reactive gas;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing station without substantially exposing the newly formed titanium layer to oxygen and/or oxygen-bearing gases by transferring said wafer through a sealed central chamber which is interconnected to both said vacuum deposition chamber and said sealed annealing chamber;

f) annealing the titanium-coated silicon semiconductor wafer in said annealing chamber at a temperature ranging from about 650°C to about 675°C in a first annealing step for a time period ranging from about 20 seconds to about 60 seconds by raising the temperature of the wafer at a rate of from about 5°C/second to about 150°C/second while maintaining a low nitrogen pressure of from about 1 Torr to about 10 Torr in said annealing chamber, and in the substantial absence of oxygen and/or oxygen-bearing gases, to form said titanium silicide as well as titanium nitride on the surface to inhibit migration of underlying silicon to the surface;

g) selectively etching said wafer after said first anneal to remove titanium nitride and unreacted titanium; and

h) then further annealing said wafer in a second annealing step at a temperature ranging from about 800°C to about 900°C.

According to a still further special aspect of the invention, the low nitrogen pressure process for forming titanium silicide on a silicon semiconductor wafer comprises the steps:

a) providing a silicon semiconductor wafer having one or more silicon surface regions on which said titanium silicide is to be formed;

b) cleaning said wafer in a sealed cleaning chamber using an rf plasma and a gaseous mixture which includes at least one reactive gas;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing station without substantially exposing the newly formed titanium layer to oxygen and/or oxygen-bearing gases by transferring said wafer through a sealed central chamber which is interconnected to both said vacuum deposition chamber and said sealed annealing chamber; and

f) annealing the titanium-coated silicon semiconductor wafer in said annealing chamber while maintaining a low nitrogen pressure of from about 500 milliTorr to about 100 Torr in said annealing chamber, and in the substantial absence of oxygen and/or oxygen-bearing gases, to form said titanium silicide as well as titanium nitride on the surface to inhibit migration of underlying silicon to the surface.

According to the aforementioned aspect, additionally, said annealing step may further include maintaining a low nitrogen pressure within said annealing chamber ranging from about 500 milliTorr to about 10 Torr, preferably about 1 Torr to about 10 Torr.

The annealing of this aspect advantageously is carried out in a first step for a time period ranging from about 20 seconds to about 60 seconds at an annealing temperature ranging from about 600° C up to about 695° C, preferably from about 650° C to about 675° C, by raising the temperature of said wafer at a rate of from about 5 to about 150° C per second.

According to a still further special aspect of the invention the low nitrogen pressure process for forming titanium silicide on a silicon-semiconductor wafer comprises the steps:

a) providing a silicon semiconductor wafer having one or more silicon surface regions on which said titanium silicide is to be formed;

b) cleaning said wafer in a sealed cleaning chamber using an rf plasma and a gaseous mixture containing at least one reactive gas;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing station without substantially exposing the newly formed titanium layer to oxygen and/or oxygen-bearing gases by transferring said wafer through a sealed central chamber which is interconnected to both said vacuum deposition chamber and said sealed annealing chamber; and

f) annealing the titanium-coated silicon semiconductor wafer in said annealing chamber at a temperature ranging from about 650° C to about 675° C while maintaining a low nitrogen pressure of from about 1 Torr to about 10 Torr in said annealing chamber, and in the substantial absence of oxygen and/or oxygen-bearing gases, to form said titanium silicide as well as titanium nitride on the surface to inhibit migration of underlying silicon to the surface.

## Claims

1. A process for forming a conductive layer of titanium silicide on a silicon semiconductor wafer which comprises:

   forming, by vacuum deposition, a titanium layer over the wafer and

   annealing the titanium-coated silicon semiconductor wafer in a nitrogen-bearing atmosphere, the whole process being carried out in the substantial absence of oxygen and/or oxygen-bearing gases, to form a titanium silicide layer as well as titanium nitride on the surface which inhibits migration of underlying silicon to the surface.

2. The process of claim 1, further comprising the step of cleaning the wafer to remove oxides and other materials from the silicon surface thereon prior to said titanium layer deposition step.

3. A process for forming a conductive layer of titanium silicide on a silicon semiconductor wafer, especially according to claim 1 or 2, which comprises:

   a. forming a titanium layer, over the wafer in a vacuum deposition chamber in the substantial absence of oxygen-bearing gases;

   b. transferring the titanium coated wafer to a sealed annealing chamber without substantially exposing the newly formed titanium layer to oxygen-bearing gases; and

   c. annealing the titanium-coated silicon semiconductor wafer in a low pressure nitrogen-bearing atmosphere in said sealed annealing chamber, and in the substantial absence of oxygen-bearing gases, to form a titanium silicide layer as well as titanium nitride on the surface which inhibits migration of underlying silicon to the surface.

4. The process of claim 3, wherein said titanium layer is formed in a thickness of 10 nm to 500 nm (100 Å to 5000 Å).

5. The process of claim 3 or 4, wherein said annealing is carried out while maintaining a nitrogen pressure in said sealed annealing chamber ranging from 130 • 10$^{-3}$mbar (100 milliTorr) to 133.3mbar (100 Torr), preferably 665 • 10$^{-3}$ mbar(500 milliTorr) to 13.33 mbar (10 Torr), and more preferably from 1.33 mbar (1 Torr) to 13.33 mbar (10 Torr).

6. The process of claim 3, 4 or 5, wherein said transferring step further includes transferring said wafer from said vacuum deposition chamber to said sealed annealing chamber through a sealed central chamber, preferably maintained at a pressure ranging from 13.33 $^{-9}$ mbar (10$^{-9}$ Torr) to 13.3 $^{-5}$ mbar (10 $^{-5}$ Torr), and which is interconnected to both said vacuum deposition chamber and said sealed annealing chamber.

7. The process of one of the preceding claims, which comprises the further steps of cleaning said wafer with a reactive rf ion plasma in a cleaning chamber to remove oxides and other materials from the silicon surface thereon prior to said titanium deposition step.

8. The process of claim 7, wherein the cleaning step further comprises cleaning said wafer using a gaseous mixture which includes at least one reactive gas while maintaining an rf plasma in said cleaning chamber by flowing into said cleaning chamber a gaseous mixture containing at least one reactive gas preferably selected from the class consisting of NF$_3$, 1-2 carbon flourinated hydrocarbons, and mixtures of same.

9. The process of claim 8, wherein said gaseous mixtures is provided to said cleaning chamber, at a rate of from 2 to 500 sccm reactive gas and from 10 to 1000 sccm carrier gas, while maintaining said plasma preferably at a power ranging from 20 to 500 watts for a period of time ranging from 1 to 500 seconds.

10. The process of one of claims 7 to 9, wherein the pressure in said cleaning chamber is maintained within a range of from 1.33 $^{-6}$ to 66.5 $^{-6}$ mbar (1 to 50 milliTorr) and/or the temperature in said cleaning chamber is within a range of from 27°C to 200°C.

11. The process of one of claims 7 to 10, wherein said cleaned wafer is transferred from said cleaning chamber to said vacuum deposition chamber, without substantially exposing said cleaned wafer to oxygen and/or one or more oxygen-bearing gases, preferably by transferring said cleaned wafer through a sealed central chamber which is interconnected to both said cleaning chamber and said vacuum deposition chamber.

12. The process of one of the preceding claims, wherein said annealing is carried out in a first annealing step at a temperature ranging from 600°C up to 695°C, preferably from 650°C up to 675°C, and/or wherein said first annealing step is carried out for a time period ranging from 20 seconds to 60 seconds whereby the temperature of said wafer is raised to the annealing temperature at a rate of from 5°C/second to 150°C/second.

13. The process of claim 12, wherein said wafer is selectively etched after said first anneal to remove titanium nitride and unreacted titanium and then subsequently annealed in a second annealing step at a temperature ranging from 800°C to 900°C.

CLEANING A SILICON SEMICONDUCTOR
WAFER IN A CLEANING CHAMBER USING
ONE OR MORE REACTIVE GASES
WITH AN RF PLASMA

MOVING THE CLEANED WAFER TO A
VACUUM DEPOSITION CHAMBER WITHOUT
EXPOSING THE CLEANED WAFER
TO OXYGEN-BEARING GASES

DEPOSITING A LAYER OF TITANIUM ON
THE CLEANED SEMICONDUCTOR WAFER

MOVING THE WAFER FROM THE VACUUM
DEPOSITION CHAMBER TO AN ANNEALING
CHAMBER WITHOUT EXPOSING THE COATED
WAFER TO OXYGEN-BEARING GASES

ANNEALING THE COATED WAFER WHILE
MAINTAINING A LOW NITROGEN
PRESSURE IN THE ANNEALING CHAMBER
OF ABOUT 0.1 - 100 TORR*
PREFERABLY ABOUT 0.5 - 10 TORR. AND
MOST PREFERABLY ABOUT 1 - 10 TORR

# Figure 1

* 1 Torr = 1.333 mbar

# Figure 2

# Figure 3

Figure 4

* / torr = /. 333 m bar